# EUROPEAN PATENT SPECIFICATION

(11) **EP 3 951 866 B1**
(45) Date of publication and mention of the grant of the patent: **03.06.2026**
(21) Application number: 20189836.8
(22) Date of filing: 06.08.2020
(51) Int. Cl.: H01L 23/498, H01L 21/48

(54) **SEMICONDUCTOR SUBSTRATE ARRANGEMENT AND METHOD FOR PRODUCING THE SAME**
HALBLEITERSUBSTRATANORDNUNG UND VERFAHREN ZUR HERSTELLUNG DAVON
AGENCEMENT DE SUBSTRAT SEMI-CONDUCTEUR ET SON PROCÉDÉ DE FABRICATION

(43) Date of publication of application: 09.02.2022
(73) Proprietor: Infineon Technologies AG, 85579 Neubiberg (DE)
(72) Inventor: HOHLFELD, Olaf, 29581 Warstein (DE); KANSCHAT, Peter, 59494 Soest (DE)
(74) Representative: Westphal, Mussgnug & Partner, Patentanwälte mbB

(56) References cited:
- US-A1- 2009 194 884
- US-A1- 2015 340 333
- US-A1- 2016 322 287
- US-A1- 2018 279 484

## Description

### TECHNICAL FIELD

The instant disclosure relates to a semiconductor substrate arrangement and to a method for producing such a semiconductor substrate arrangement.

### BACKGROUND

Power semiconductor module arrangements often include a base plate within a housing. At least one substrate is arranged on the base plate. A semiconductor arrangement including a plurality of controllable semiconductor elements (e.g., two IGBTs in a half-bridge configuration) is arranged on each of the at least one substrates. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer is usually attached to the base plate by means of a solder layer or a sintering layer. The substrate and the semiconductor elements mounted thereon may be electrically coupled to the outside of the housing by means of terminal elements, for example. Such terminal elements may comprise a sleeve, hollow rivet or hollow bushing and a connection pin. The sleeve, hollow rivet or hollow bushing may be firmly attached to the substrate, e.g., by means of a solder connection. The connection pin may be inserted into the sleeve, hollow rivet or hollow bushing such that the sleeve, hollow rivet or hollow bushing fits over and encompasses a first end of the connection pin. A second end of the connection pin may protrude out of the housing such that the connection pin can be electrically contacted from the outside of the housing.

The at least one substrate, the solder connection, and the sleeve, hollow rivet or hollow bushing usually have different CTEs (coefficients of thermal expansion). When heat is generated during the operation of the semiconductor arrangement, and when the different components subsequently cool down again, the difference between the CTEs of the different materials (e.g., copper, aluminum, solder) may result in unwanted cracks in the solder connection. The formation of cracks may also be caused by tolerances that arise during the production of the arrangement. Such cracks may adversely affect the mechanical and electrical connection formed between the substrate and the sleeve, hollow rivet or hollow bushing and even lead to the complete failure of the connection.

Document US 2018/279484 A1 discloses a semiconductor device. After a contact component is disposed in a concave joint space, when a solder solidifies, the solder thickness of the solder in the joint space is kept. Thus, a contact area between the contact component and the solder is kept, and the solder thickness of the solder that joins the contact component and a conductive pattern is kept. In addition, since an appropriate amount of the solder is kept in the joint space, an extra amount of solder does not need to be applied in advance. As a result, there is prevented creeping up of the solder into a hollow hole of the contact component, caused by the heat applied when the contact component is joined to the conductive pattern.

Document US 2016/322287 A1 discloses a semiconductor device in which an implant board and a semiconductor element of a semiconductor mounting board are bonded and electrically connected through implant pins. Implant pins are bonded to a semiconductor element and/or a circuit pattern of a semiconductor mounting board through cylindrical terminals press-fitted into the other ends of the implant pins. Press-fitting depth of each of the implant pins into corresponding cylindrical terminals is adjustable, so that total length of the implant pin and cylindrical terminal which are press-fitted to each other matches up with the distance between the semiconductor element and/or the circuit pattern on the semiconductor mounting board and an implant board.

There is a need for a substrate arrangement that reduces, or better even avoids, the aforementioned and other drawbacks and which allows producing power semiconductor module arrangements with increased performance and reliability, and for a method for producing such a substrate arrangement.

### SUMMARY

A substrate arrangement includes a substrate including a dielectric insulation layer and a first metallization layer attached to the dielectric insulation layer, a connection layer arranged on the first metallization layer, and a hollow rivet, wherein the first metallization layer comprises at least one protrusion and at least one recess, the connection layer at least partly covers the at least one protrusion and the at least one recess, the hollow rivet is arranged on the connection layer such that the connection layer is arranged between the hollow rivet and the first metallization layer, and between the hollow rivet and the at least one protrusion and the at least one recess. Each of the at least one protrusion includes a recess on its top surface, wherein a top surface of the protrusion is a surface which faces away from the first metallization layer, and the protrusion, when the pointed tip of a terminal element is pressed into the recess on the top surface of the protrusion, and a force is applied with the terminal element in a vertical direction, is configured to partly split and caulk against the hollow rivet.

A method includes arranging a connection layer on a substrate, the substrate comprising a dielectric insulation layer and a first metallization layer attached to the dielectric insulation layer, and arranging a hollow rivet on the connection layer, wherein the first metallization layer comprises at least one protrusion and at least one recess, the connection layer is arranged on the substrate to at least partly cover the at least one protrusion and/or the at least one recess, and the hollow rivet is arranged on the connection layer such that the connection layer is arranged between the hollow rivet and the first metallization layer, and between the hollow rivet and the at least one protrusion and/or the at least one recess. Each of the at least one protrusion includes a recess on its top surface, wherein a top surface of the protrusion is a surface which faces away from the first metallization layer, and the protrusion, when the pointed tip of a terminal element is pressed into the recess on the top surface of the protrusion, and a force is applied with the terminal element in a vertical direction, is configured to partly split and caulk against the hollow rivet.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

In the following, the arrangements in Figs. 1-12, 14 and 15 are not part of the claimed invention.
Figure 1 is a cross-sectional view of a power semiconductor module arrangement.
Figure 2 schematically illustrates a cross-sectional view of a substrate arrangement.
Figure 3 schematically illustrates a cross-sectional view of a hollow rivet mounted on a metallization layer.
Figure 4, which includes Figures 4A and 4B, schematically illustrates different forces occurring in a substrate arrangement.
Figure 5 schematically illustrates a cross-sectional view of a substrate arrangement according to one example.
Figure 6 schematically illustrates a cross-sectional view of a substrate arrangement according to another example.
Figure 7 schematically illustrates a cross-sectional view of a substrate arrangement according to another example.
Figure 8, which includes Figures 8A and 8B, schematically illustrates a method for producing a substrate arrangement according to one example.
Figure 9 schematically illustrates a cross-sectional view of a substrate arrangement according to another example.
Figure 10 schematically illustrates a cross-sectional view of a substrate arrangement according to an example.
Figure 11 schematically illustrates a top view (top) and a cross-sectional view (bottom) of a metallization layer of a substrate arrangement according to one example.
Figure 12 schematically illustrates a top view (top) and a cross-sectional view (bottom) of a hollow rivet of a substrate arrangement according to one example.
Figure 13, which includes Figures 13A and 13B, schematically illustrates cross-sectional views of a substrate arrangement according to an even further example.
Figure 14 schematically illustrates a cross-sectional view of a substrate arrangement according to another example.
Figure 15, which includes Figures 15A to 15D, schematically illustrates cross-sectional views of substrate arrangements according to further examples.

### DETAILED DESCRIPTION

In the following detailed description, reference is made to the accompanying drawings. The drawings show specific examples of how the invention can be implemented. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead such designations serve solely to denote different "elements". That is, e.g., the existence of a "third element" does not necessarily require the existence of a "first element" or a "second element". An electrical line or electrical connection as described herein may be a single electrically conductive element, or include at least two individual electrically conductive elements connected in series and/or parallel. Electrical lines and electrical connections may include metal and/or semiconductor material and may be permanently electrically conductive (i.e., non-switchable). A semiconductor body as described herein may be made of (doped) semiconductor material and may be a semiconductor chip or be included in a semiconductor chip. A semiconductor body has electrically connectable pads and includes at least one semiconductor element with electrodes.

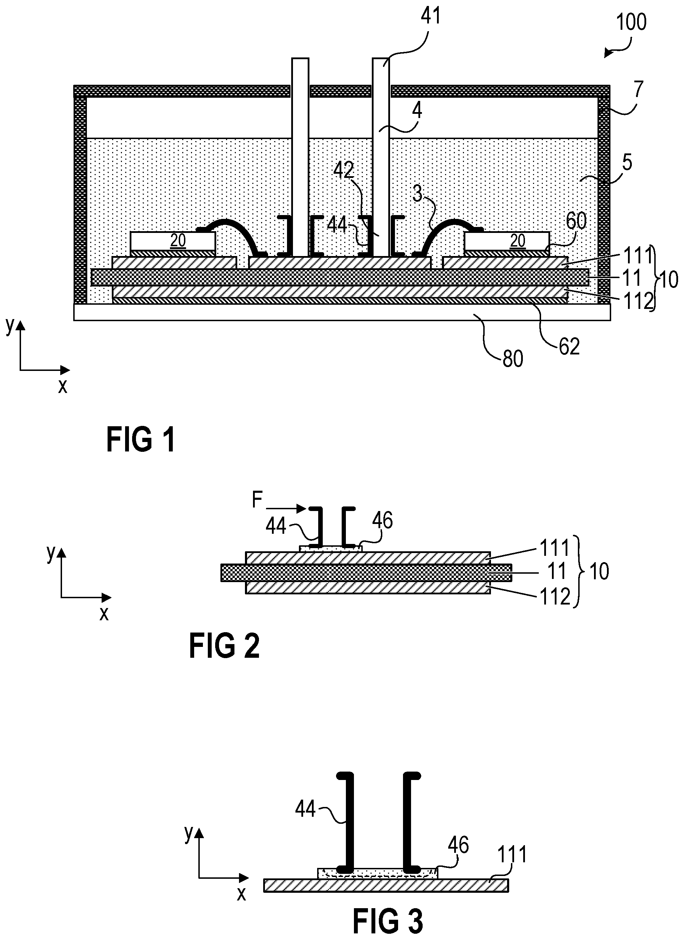

Referring to Figure 1, a cross-sectional view of a power semiconductor module arrangement 100 is illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. Alternatively, the dielectric insulation layer 11 may consist of an organic compound and include one or more of the following materials: Al₂O₃, AlN, SiC, BeO, BN, or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., Si₂O, Al₂O₃, AlN, SiN or BN and may have a diameter of between about 1µm and about 50µm. The substrate 10 may also be a conventional printed circuit board (PCB) that has a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 is arranged on a base plate 80 which forms a base surface of the housing 7, while the housing 7 itself solely comprises sidewalls and a cover. In some power semiconductor module arrangements 100, more than one substrate 10 is arranged on the same base plate 80 and within the same housing 7. The base plate 80 may comprise a layer of a metallic material such as, e.g., copper or AlSiC. Other materials, however, are also possible.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. According to another example, the second metallization layer 112 may be a structured layer. According to other examples, the second metallization layer 112 may be omitted altogether. The first metallization layer 111 is a structured layer in the example illustrated in Figure 1. "Structured layer" in this context means that the respective metallization layer is not a continuous layer, but includes recesses between different sections of the layer. Such recesses are schematically illustrated in Figure 1. The first metallization layer 111 in this example includes three different sections. Different semiconductor bodies 20 may be mounted to the same or to different sections of the first metallization layer 111. Different sections of the first metallization layer may have no electrical connection or may be electrically connected to one or more other sections using electrical connections 3 such as, e.g., bonding wires. Semiconductor bodies 20 may be electrically connected to each other or to the first metallization layer 111 using electrical connections 3, for example. Electrical connections 3, instead of bonding wires, may also include bonding ribbons, connection plates or conductor rails, for example, to name just a few examples. The one or more semiconductor bodies 20 may be electrically and mechanically connected to the substrate 10 by an electrically conductive connection layer 60. Such an electrically conductive connection layer 60 may be a solder layer, a layer of an electrically conductive adhesive, or a layer of a sintered metal powder, e.g., a sintered silver (Ag) powder, for example.

The power semiconductor module arrangement 100 illustrated in Figure 1 further includes terminal elements 4. The terminal elements 4 provide an electrical connection between the inside and the outside of the housing 7. The terminal elements 4 may be electrically connected to the first metallization layer 111 with a second end 42, while a first end 41 of the terminal elements 4 protrudes out of the housing 7. The terminal elements 4 may be electrically contacted from the outside at their first end 41. Arranging the terminal elements 4 centrally on the substrate 10 is only an example. According to other examples, terminal elements 4 may be arranged closer to or adjacent to the sidewalls of the housing 7. The second end 42 of a terminal element 4 may be electrically and mechanically connected to the substrate 10 by a sleeve, hollow rivet or hollow bushing 44, in the following only referred to as hollow rivet, for example. The hollow rivet 44 may be electrically and mechanically coupled to the first metallization layer 111 of the substrate 10 by means of an electrically conductive connection layer (not specifically illustrated in Figure 1). Such an electrically conductive connection layer may be a solder layer, a layer of an electrically conductive adhesive, or a layer of a sintered metal powder, e.g., a sintered silver (Ag) powder, for example. The hollow rivet 44 may comprise a tubular part, and the second end 42 of the terminal element 4 may be inserted into the hollow rivet 44. The hollow rivet 44, therefore, encloses the second end 42 of the terminal element 4, when the terminal element 4 is inserted in the hollow rivet 44. The connection formed between the terminal element 4 and the hollow rivet 44, therefore, may not be permanent. The terminal element 4 can be removed by pulling it out of the hollow rivet 44. However, the hollow rivet 44 may fit tightly around the terminal element 4 so as to provide a stable electrical connection between the two parts.

The power semiconductor module arrangement 100 may further include an encapsulant 5. The encapsulant 5 may consist of or include a silicone gel or may be a rigid molding compound, for example. The encapsulant 5 may at least partly fill the interior of the housing 7, thereby covering the components and electrical connections that are arranged on the substrate 10. The terminal elements 4 may be partly embedded in the encapsulant 5. At least their first ends 41, however, are not covered by the encapsulant 5 and protrude from the encapsulant 5 through the housing 7 to the outside of the housing 7. The encapsulant 5 is configured to protect the components and electrical connections of the power semiconductor module 100, in particular the components arranged inside the housing 7, from certain environmental conditions and mechanical damage. It is generally also possible to omit the housing 7 and solely protect the substrate 10 and any components mounted thereon with an encapsulant 5. In this case, the encapsulant 5 may be a rigid material, for example.

During as well as after the assembly of the power semiconductor module arrangement 100, the terminal element 4 and the hollow rivet 44 may be subjected to great forces. This is because the opening in the housing 7 through which the terminal element 4 protrudes to the outside of the housing 7, e.g., due to production tolerances, may not be perfectly aligned with the corresponding hollow rivet 44. The terminal elements 4 may also be mechanically and electrically coupled to a printed circuit board (not specifically illustrated) arranged above and parallel to the substrate 10. The terminal elements 4 may protrude through holes provided in such a printed circuit board in order to form a connection between the terminal elements 4 and the printed circuit board. Ideally, the terminal element 4 is inserted into the hollow rivet 44 in a perfectly vertical direction y. If, however, the opening in the housing 7 or the holes in a printed circuit board are not arranged directly above the hollow rivet 44 in the vertical direction y, the terminal element 4 may be inserted into the hollow rivet 44 with a certain inclination. The hollow rivet 44, which is fixed to the substrate 10 by means of a connection layer 46, therefore may be subjected to a force F in a horizontal direction x. This is schematically illustrated in Figure 2. Figure 2 schematically illustrates in a cross-sectional view a substrate arrangement with a substrate 10, a hollow rivet 44, and a connection layer 46 arranged between the substrate 10 and the hollow rivet 44. The force F is schematically indicated by means of an arrow in Figure 2.

Because of this force F, the connection layer 46 may also be subjected to great forces, as the force F tries to push the hollow rivet 44 out of its fixed position. Furthermore, when the power semiconductor module arrangement is in use, the substrate 10, the connection layer 46 and the hollow rivet 44 may be heated to a certain degree. This is because at least some semiconductor bodies 20 of the power semiconductor module arrangement 100 generally perform a plurality of switching operations during the operation of the power semiconductor module arrangement 100. When performing many switching operations within a short period of time, for example, the semiconductor bodies 20 generate heat which, in the worst case, may rise to a temperature above a certain maximum threshold. Heat generated during the operation of the power semiconductor module arrangement 100 is usually dissipated from the semiconductor bodies 20 to the substrate 10 and further through the base plate 80 to a heat sink (not specifically illustrated in Figure 1).

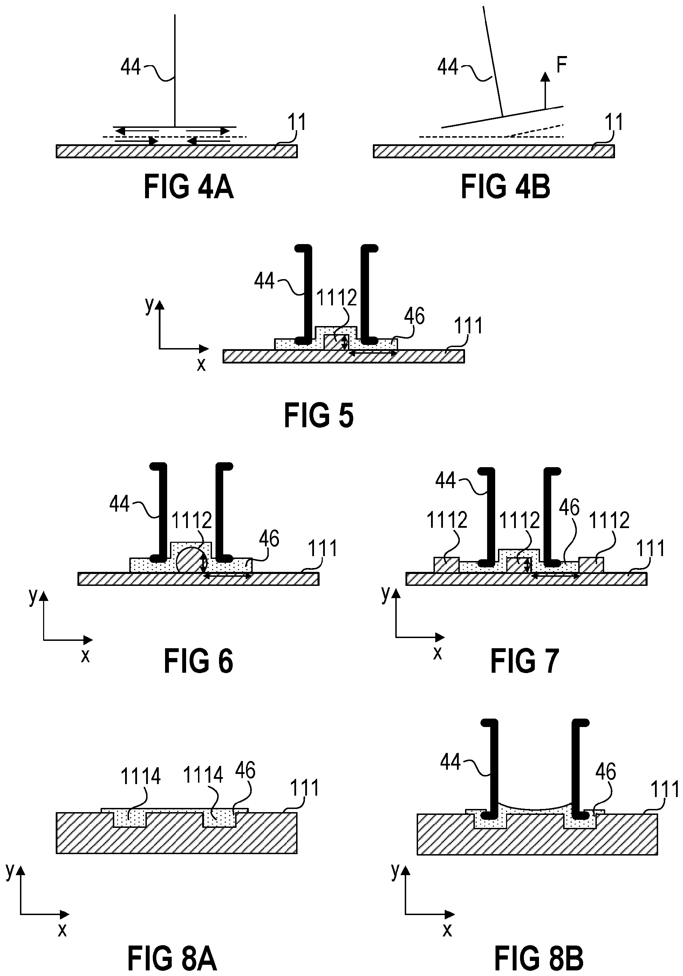

This heat is also transferred through the substrate 10 to the connection layer 46 and the hollow rivet. The forces which the connection layer 46 is subjected to, as well as increased temperatures, may cause cracks to form in the connection layer 46. Such a crack is schematically illustrated with a dashed line in Figure 3. Another reason for the possible formation of cracks is the fact that the materials of the first metallization layer 111, the connection layer 46, and the hollow rivet 44 generally have different thermal expansion coefficients. That is, when heated, the different materials expand to different degrees. The same applies when the materials subsequently cool down again. This is schematically illustrated by means of arrows in Figure 4A. The arrows specifically illustrate the shear stress that the connection layer 46 is subjected to when heating or cooling the different components. The horizontal force F illustrated in Figure 2 may be transformed into a vertical force F, as is schematically illustrated in Figure 4B. Such a vertical, or essentially vertical, force F may pull the hollow rivet 44 away from the substrate 10, which may lead to further cracks in the connection layer. This is schematically illustrated by means of dashed lines in Figure 4B. An essentially vertical force F, as illustrated in Figure 4B, may also be induced due to tolerances or misalignment of the holes in a printed circuit board and the terminal elements 4 when mounting the printed circuit board to the arrangement, as has already been mentioned above.

The cracks in the connection layer 46 may negatively affect the mechanical and electrical connection between the substrate 10 and the hollow rivet 44 and may even lead to the complete failure of the power semiconductor module arrangement.

Now referring to Figure 5, a substrate arrangement according to one example is exemplarily illustrated. The substrate arrangement comprises a substrate 10, of which only the first metallization layer 111 is schematically illustrated in Figure 5, a hollow rivet 44 arranged on the substrate 10, and a connection layer 46 arranged between the hollow rivet 44 and the first metallization layer 111. The first metallization layer 111 in this example comprises a protrusion 1112. The connection layer 46 covers part of the first metallization layer 111 and at least partly covers the protrusion 1112. In the example illustrated in Figure 5, the connection layer 46 completely covers the protrusion 1112. That is, the connection layer 46 covers the sidewalls and a top surface of the protrusion 1112. It is, however, also possible, that the top surface of the protrusion 1112 is not or only partly covered by the connection layer 46. The hollow rivet 44 is arranged on the first metallization layer 111 such that the connection layer 46 is arranged between the hollow rivet 44 and the first metallization layer 111 in the vertical direction y, and between the protrusion 1112 and the hollow rivet 44 in a horizontal direction x. In the example illustrated in Figure 5, the hollow rivet 44 is arranged on the first metallization layer 111 such that the protrusion 1112 protrudes into the inside of the hollow rivet 44. That is, the protrusion 1112 is at least partly surrounded by the hollow rivet 44.

The protrusion 1112 may be formed on the first metallization layer 111 by means of an additive process. That is, material may be deposited on the top surface of the first metallization layer. Such an additive process may comprise a cold spray process, electrolytic deposition, or applying a bond ball (e.g., copper bond ball), for example.

The protrusion illustrated in Figure 5 has an angular cross-section. The protrusion 1112 may have a generally cylindrical or cube-shaped form, for example. According to another example, which is schematically illustrated in Figure 6, the protrusion 1112 may have an essentially spherical shape and, therefore, an essentially round or oval cross-section. Any other shapes and cross-sections, however, are also possible.

The substrate arrangement may comprise one or more protrusions 1112. An exemplary substrate arrangement comprising more than one protrusion is schematically illustrated in Figure 7. In the example illustrated in Figure 7, the substrate arrangement further comprises a second protrusion 1112. The hollow rivet 44, as has been described above, may comprise a tubular part. This tubular part may surround the first protrusion 1112 (see, e.g., Figures 5 and 6) horizontally, and the second protrusion 1112 may surround the tubular part horizontally. That is, the second protrusion 1112 may form a closed loop around the hollow rivet 44.

In this way, the connection layer 46 has horizontal portions which generally extend horizontally on the first metallization layer 111, as well as vertical portions which generally extend vertically along the sidewalls of the at least one protrusion 1112. On the one hand, this increases the size of the contact surface between the contact layer 46 and the substrate 10 (the substrate 10 comprising the first metallization layer 111 and the at least one protrusion 1112). On the other hand, the direction of a strain which the connection layer 46 is subjected to is redirected from a purely horizontal direction to a partly vertical direction. This is schematically illustrated by means of arrows in Figures 5, 6 and 7.

The first metallization layer 111 comprising at least one protrusion 1112, however, is only an example. Alternatively or additionally, at least one recess 1114 may be formed in the first metallization layer 111. This is schematically illustrated in Figure 8, for example. According to one example, at least one recess 1114 may be formed in the first metallization layer 1114. Such a recess 1114 may be formed by means of an etching process, for example. The at least one recess 1114 may then be at least partly filled with the material of the connection layer 46, as is schematically illustrated in Figure 8A. The hollow rivet 44 may subsequently be arranged on the first metallization layer 111 such that it is at least partly arranged in the at least one recess 1114. This is schematically illustrated in Figure 8B. In this example, the connection layer 46 is not only arranged in the recess 1114, but also partly covers a top surface of the first metallization layer 111. Initially, a surface of the connection layer 46 may be essentially even (see, e.g., Figure 8A). When the hollow rivet 44 is pressed into the material of the connection layer 46 and into the recess 1114, some of the material may be driven out of the recess 1114 resulting in an uneven surface of the connection layer 46 (see, e.g., Figure 8B).

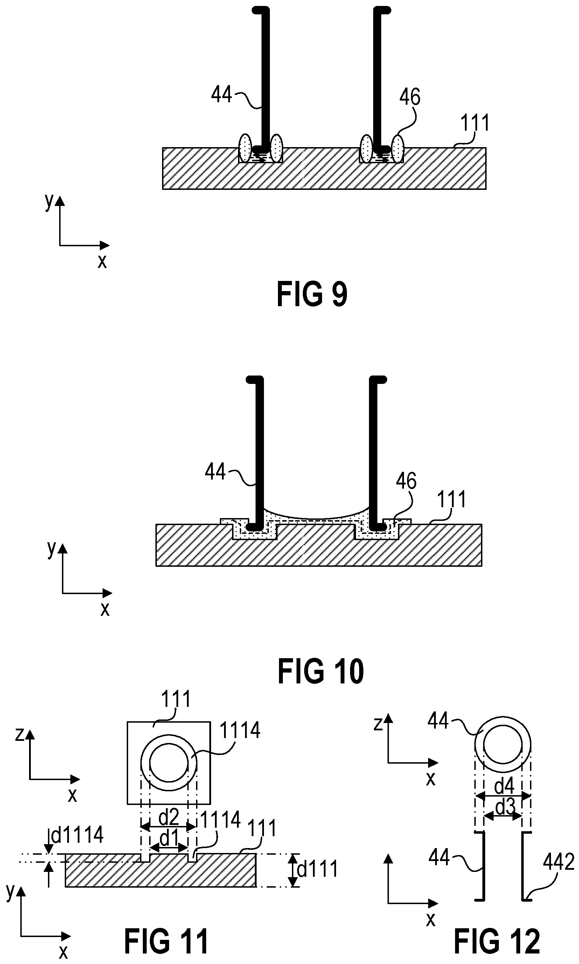

Similar to what has been described above with respect to Figures 5, 6 and 7, forming a recess 1114 in the first metallization layer 111 and arranging the hollow rivet in the recess 1114, with the connection layer 46 arranged between the bottom and the sidewalls of the recess 1114 and the hollow rivet 44 results in essentially vertical sections of the connection layer 46. Such vertical sections of the connection layer 46 are emphasized by means of ovals in Figure 9. In this way, shear stress may occur vertically below the hollow rivet 44 between the hollow rivet 44 and the bottom of the recess 1114 (illustrated with small arrows in Figure 9). The vertical sections of the connection layer 46, however, prevent the shear stress from occurring throughout the complete connection layer 46. The vertical sections are not subjected to shear stress, or only to a significantly lower degree as compared to the horizontal sections of the connection layer 46. That is, the vertical sections of the connection layer 46 prevent cracks from extending throughout the complete connection layer 46. The vertical sections instead interrupt the spread of any cracks that form in the connection layer 46.

Now referring to Figure 10, a crack formed in a connection layer 46 of an embodiment according to one example is schematically illustrated by means of a dashed line. As can be seen, a crack completely extending through the connection layer 46 would need to have both horizontal sections as well as vertical sections. Even further, the overall length of a crack would be significantly larger as compared to the crack in the arrangement illustrated in Figure 3. Therefore, the risk of such a crack forming in the connection layer 46 in the examples illustrated in Figures 5 to 10 is significantly reduced as compared to the arrangement illustrated in Figures 2 and 3.

Now referring to Figure 11, a top view (Figure 11 top) and a cross-sectional view (Figure 11 bottom) of an exemplary recess 1114 are schematically illustrated. As can be seen in the top view and as has been described above, the recess 1114 may form a closed loop. This closed loop may have a circular shape, as is illustrated in Figure 11, for example. The closed loop, however, may also have different shapes such as an oval or angular shape, for example. The shape of the recess 1114 may depend on the shape of the hollow rivet 44, for example, such that the hollow rivet 44 may be arranged partly inside the recess 1114 without being in direct contact with the sidewalls of the recess 1114.

The recess 1114, in those cases where it has a circular shape, may have an outer diameter d2 and an inner diameter d1, as is illustrated in Figure 11. The hollow rivet 44 may also have an inner diameter d3 and an outer diameter d4, as is illustrated in Figure 12. Figure 12 schematically illustrates a top view (Figure 12 top) and a cross-sectional view (Figure 12 bottom) of an exemplary hollow rivet 44. The hollow rivet according to the example of Figure 12 also has a circular shape forming a closed loop (see Figure 12 top). The outer diameter d2 of the recess 1114 may be larger than the outer diameter d4 of the hollow rivet 44, and the inner diameter d1 of the recess 1114 may be smaller than the inner diameter d3 of the hollow rivet 44. According to one example, the outer diameter d2 of the recess 1114 is between 50µm (micrometer) and 2mm (millimeter) larger than the outer diameter d4 of the hollow rivet 44. That is, the following may apply (d4 + 50µm) ≤ d2 ≤ (d4 + 2mm). According to another example, the outer diameter d2 of the recess 1114 may be between 100µm and 400µm larger than the outer diameter d4 of the hollow rivet 44. That is, according to the second example, the following may apply (d4 + 100µm) ≤ d2 ≤ (d4 + 400µm). According to one example, the inner diameter d1 of the recess 1114 may be between 50µm and 500µm smaller than the inner diameter d3 of the hollow rivet 44. That is, the following may apply (d3 - 500µm) ≤ d1 ≤ (d3 - 50µm).

The first metallization layer 111 may have a thickness d111 in the vertical direction y between 0.2mm and 1mm. The recess 1114 may have a depth d1114 in the vertical direction y between 100µm and 0.95mm. According to one example, the following may apply d1114 = 0.5 * d111. According to another example, d1114 = d111 - 50µm.

As is illustrated in Figures 5 to 12, the hollow rivet 44 may comprise a tubular part and at least one collar 442 which terminates the tubular part in the vertical direction y. An extension of such a collar 442 in a horizontal direction (e.g., first horizontal direction x) is generally larger than a dimension (thickness) of the tubular part in the same direction. The inner diameter and outer diameter of the hollow rivet 44, therefore, may refer to the dimensions of the collar 442.

This may similarly apply if the arrangement comprises a protrusion 1112 instead of or in addition to the recess 1114. That is, a diameter of the protrusion 1112 may be smaller than the inner diameter d3 of the hollow rivet 44. According to one example, the diameter of the protrusion 1112 may be between 50µm and 500µm smaller than the inner diameter d3 of the hollow rivet 44. A height of a protrusion 1112 in the vertical direction may be between 100µm and 2mm, for example.

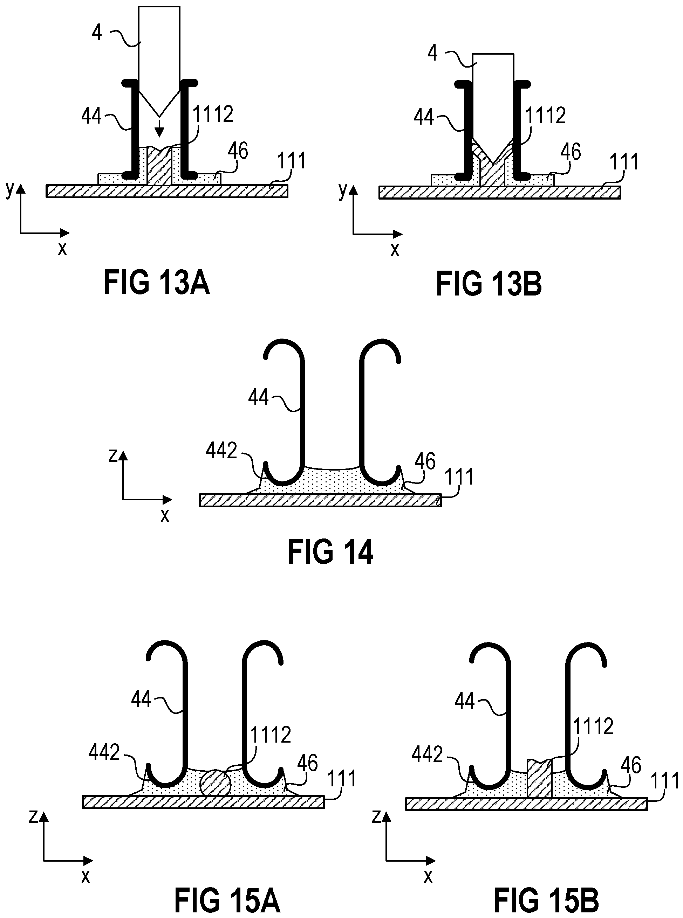

Now referring to Figure 13, an arrangement according to an even further example is schematically illustrated. Figure 13A illustrates the arrangement wherein a terminal element 4 is inserted partly into the hollow rivet 44. Figure 13B illustrates the arrangement with the terminal element 4 fully inserted in the hollow rivet 44. The arrangement illustrated in Figure 13 comprises a protrusion 1112. The protrusion 1112 comprises a recess on its top surface, wherein a top surface of the protrusion 1112 is a surface which faces away from the first metallization layer 111. The terminal element at its second end 42 may comprise a pointed tip. When the terminal element 4 is inserted into the hollow rivet 44, the pointed tip is pressed into the recess on the top surface of the protrusion 1112. By applying a force in the vertical direction y with the terminal element 4, the protrusion 1112 can be partly split and can be pushed towards the tubular part of the hollow rivet 44. In this way, the protrusion 1112 can be caulked against the hollow rivet 44. In this example, the connection layer 46 may surround the protrusion 1112, but may not cover the top surface of the protrusion 1112. That is, when the terminal element 4 is pressed on the protrusion 1112, the connection layer 46 is not arranged between the protrusion 1112 and the terminal element 4.

In the examples described above, the collar 442 of the hollow rivet 44 is comparably small. The collar 442 in these examples comprises a part which extends essentially perpendicular to the tubular part of the hollow rivet. That is, the collar 442 is essentially flat and extends in a horizontal plane. An increase of the contact surface of the connection layer 46 is obtained mainly by forming a protrusion 1112 on or a recess in the first metallization layer 111, or both, as has been described above.

Now referring to Figure 14, an increase of the contact surface of the connection layer 46 may also be obtained by enlarging the collar 442 of the hollow rivet 44. The collar 442 in this example has a rounded shape. A dimension of the collar 442 illustrated in Figure 14 in a horizontal direction may be significantly larger as compared to the examples illustrated in Figure 5 to 13 above. In this way the contact surface between the connection layer 46 and the hollow rivet 44 can be increased.

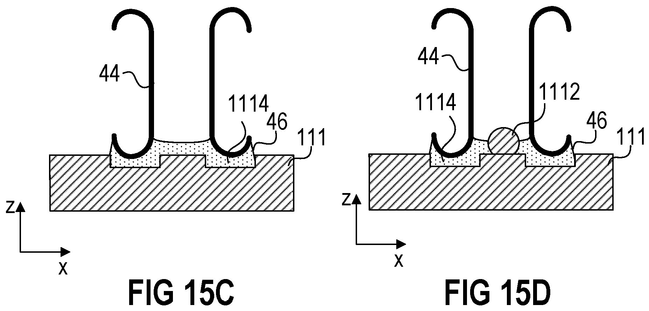

The enlarged collar 442 may be combined with any of the arrangements described above, as is schematically illustrated in Figure 15A to 15D which show different examples of protrusions 1112 and recesses 1114, and combinations thereof.

## Claims

1. A substrate arrangement comprising:
a substrate (10) comprising a dielectric insulation layer (11) and a first metallization layer (111) attached to the dielectric insulation layer (11);
a connection layer (46) arranged on the first metallization layer (111); and
a hollow rivet (44), wherein
the first metallization layer (111) comprises at least one protrusion (1112),
the connection layer (46) at least partly covers the at least one protrusion (1112), and
the hollow rivet (44) is arranged on the connection layer (46) such that the connection layer (46) is arranged between the hollow rivet (44) and the first metallization layer (111), and between the hollow rivet (44) and the at least one protrusion (1112), **characterized in that**
each of the at least one protrusion (1112) comprises a recess on its top surface, wherein a top surface of the protrusion (1112) is a surface which faces away from the first metallization layer (111), and
the protrusion (1112), when the pointed tip of a terminal element (4) is pressed into the recess on the top surface of the protrusion (1112), and a force is applied with the terminal element (4) in a vertical direction (y), is configured to partly split and caulk against the hollow rivet (44).

2. The substrate arrangement of claim 1, wherein the connection layer (46) is arranged between the hollow rivet (44) and the first metallization layer (111) in the vertical direction (y), and between the hollow rivet (44) and the at least one protrusion (1112) in a horizontal plane perpendicular to the vertical direction (y).

3. The substrate arrangement of claim 1 or 2, wherein
each of the at least one protrusion (1112) has a cylindrical, cube-shaped, or spherical shape.

4. The substrate arrangement of claim 3, wherein
the first metallization layer (111) further comprises a recess (1114) forming a closed loop,
the recess (1114) comprises an inner diameter (d1) and an outer diameter (d2),
the hollow rivet (44) forms a closed loop comprising an inner diameter (d3) and an outer diameter (d4),
the inner diameter (d1) of the recess (1114) is smaller than the inner diameter (d3) of the hollow rivet (44), and
the outer diameter (d2) of the recess (1114) is larger than the outer diameter (d4) of the hollow rivet (44).

5. The substrate arrangement of claim 4, wherein at least one of
the inner diameter (d1) of the recess (1114) is between 50µm and 500µm smaller than the inner diameter (d3) of the hollow rivet (44), and
the outer diameter (d2) of the recess (1114) is between 50µm and 2mm larger than the outer diameter (d4) of the hollow rivet (44).

6. The substrate arrangement of claim 5, wherein the outer diameter (d2) of the recess (1114) is between 100µm and 400µm larger than the outer diameter (d4) of the hollow rivet (44).

7. The substrate arrangement of any of claims 4 to 6, wherein a thickness (d111) of the first metallization layer (111) in the vertical direction (y) is greater than a depth (d1114) of the at least one recess (1114) in the same direction.

8. The substrate arrangement of claim 7, wherein
either the depth (d1114) of the at least one recess (1114) in the vertical direction (y) is between 100µm and 0.95mm; or
the depth (d1114) of the at least one recess (1114) in the vertical direction (y) is 0.5 times the thickness (d111) of the first metallization layer (111) in the vertical direction (y); or
the depth (d1114) of the at least one recess (1114) in the vertical direction (y) is 50µm less than the thickness (d111) of the first metallization layer (111) in the vertical direction (y).

9. The substrate arrangement of any of claims 1 to 8, wherein
a diameter of the protrusion (1112) is smaller than the inner diameter (d3) of the hollow rivet (44).

10. The substrate arrangement of any of the preceding claims, wherein
a diameter of the protrusion (1112) in a horizontal plane is between 50µm and 500µm smaller than the inner diameter (d3) of the hollow rivet (44).

11. The substrate arrangement of any of the preceding claims, wherein
a height of the protrusion (1112) in the vertical direction (y) is between 100µm and 2mm.

12. The substrate arrangement of any of the preceding claims, wherein the hollow rivet (44) comprises a tubular part and at least one collar (442) which terminates the tubular part in the vertical direction (y), wherein the at least one collar (442) has a rounded shape and extends from the tubular part in a horizontal direction.

13. A method comprising:
arranging a connection layer (46) on a substrate (10), the substrate (10) comprising a dielectric insulation layer (11) and a first metallization layer (111) attached to the dielectric insulation layer (11); and
arranging a hollow rivet (44) on the connection layer (46), wherein
the first metallization layer (111) comprises at least one protrusion (1112) and/or at least one recess (1114),
the connection layer (46) is arranged on the substrate (10) to at least partly cover the at least one protrusion (1112) and/or the at least one recess (1114), **characterized in that**
the hollow rivet (44) is arranged on the connection layer (46) such that the connection layer (46) is arranged between the hollow rivet (44) and the first metallization layer (111), and between the hollow rivet (44) and the at least one protrusion (1112) and/or the at least one recess (1114), wherein
each of the at least one protrusion (1112) comprises a recess on its top surface, wherein a top surface of the protrusion (1112) is a surface which faces away from the first metallization layer (111), and
the protrusion (1112), when the pointed tip of a terminal element (4) is pressed into the recess on the top surface of the protrusion (1112), and a force is applied with the terminal element (4) in a vertical direction (y), is configured to partly split and caulk against the hollow rivet (44).

14. The method of claim 13, wherein the at least one protrusion (1112) is formed by means of a cold spray process, an electrolytic deposition process, or a ball bonding process.

## Patentansprüche

1. Substratanordnung, die Folgendes umfasst:
ein Substrat (10), das eine dielektrische Isolationsschicht (11) und eine erste Metallisierungsschicht (111) umfasst, die an der dielektrischen Isolationsschicht (11) angebracht ist;
eine Verbindungsschicht (46), die auf der ersten Metallisierungsschicht (111) angeordnet ist; und
einen Hohlniet (44), wobei
die erste Metallisierungsschicht (111) mindestens einen Vorsprung (1112) umfasst,
die Verbindungsschicht (46) den mindestens einen Vorsprung (1112) zumindest teilweise bedeckt, und
der Hohlniet (44) so auf der Verbindungsschicht (46) angeordnet ist, dass die Verbindungsschicht (46) zwischen dem Hohlniet (44) und der ersten Metallisierungsschicht (111) und zwischen dem Hohlniet (44) und dem mindestens einen Vorsprung (1112) angeordnet ist, **dadurch gekennzeichnet, dass**
jeder des mindestens einen Vorsprungs (1112) eine Vertiefung auf seiner oberen Fläche umfasst, wobei eine obere Fläche des Vorsprungs (1112) eine von der ersten Metallisierungsschicht (111) abgewandte Fläche ist, und der Vorsprung (1112), wenn die zulaufende Spitze eines Anschlusselements (4) in die Vertiefung auf der oberen Fläche des Vorsprungs (1112) gedrückt wird und eine Kraft mit dem Anschlusselement (4) in einer vertikalen Richtung (y) ausgeübt wird, dazu ausgelegt ist, sich teilweise zu teilen und gegen den Hohlniet (44) zu verstemmen.

2. Substratanordnung nach Anspruch 1, wobei die Verbindungsschicht (46) in der vertikalen Richtung (y) zwischen dem Hohlniet (44) und der ersten Metallisierungsschicht (111) und in einer horizontalen Ebene senkrecht zur vertikalen Richtung (y) zwischen dem Hohlniet (44) und dem mindestens einen Vorsprung (1112) angeordnet ist.

3. Substratanordnung nach Anspruch 1 oder 2, wobei jeder des mindestens einen Vorsprungs (1112) eine zylindrische, würfelförmige oder kugelförmige Form aufweist.

4. Substratanordnung nach Anspruch 3, wobei
die erste Metallisierungsschicht (111) ferner eine Vertiefung (1114) umfasst, die eine geschlossene Schleife bildet,
die Vertiefung (1114) einen Innendurchmesser (d1) und einen Außendurchmesser (d2) umfasst,
der Hohlniet (44) eine geschlossene Schleife bildet, die einen Innendurchmesser (d3) und einen Außendurchmesser (d4) umfasst,
der Innendurchmesser (d1) der Vertiefung (1114) kleiner als der Innendurchmesser (d3) des Hohlniets (44) ist, und der Außendurchmesser (d2) der Vertiefung (1114) größer als der Außendurchmesser (d4) des Hohlniets (44) ist.

5. Substratanordnung nach Anspruch 4, wobei mindestens eines von Folgendem gilt
der Innendurchmesser (d1) der Vertiefung (1114) ist zwischen 50 µm und 500 µm kleiner als der Innendurchmesser (d3) des Hohlniets (44), und
der Außendurchmesser (d2) der Vertiefung (1114) ist zwischen 50 µm und 2 mm größer als der Außendurchmesser (d4) des Hohlniets (44).

6. Substratanordnung nach Anspruch 5, wobei der Außendurchmesser (d2) der Vertiefung (1114) zwischen 100 µm und 400 µm größer als der Außendurchmesser (d4) des Hohlniets (44) ist.

7. Substratanordnung nach einem der Ansprüche 4 bis 6, wobei eine Dicke (d111) der ersten Metallisierungsschicht (111) in der vertikalen Richtung (y) größer als eine Tiefe (d1114) der mindestens einen Vertiefung (1114) in der gleichen Richtung ist.

8. Substratanordnung nach Anspruch 7, wobei
entweder die Tiefe (d1114) der mindestens einen Vertiefung (1114) in der vertikalen Richtung (y) zwischen 100 µm und 0,95 mm beträgt; oder
die Tiefe (d1114) der mindestens einen Vertiefung (1114) in der vertikalen Richtung (y) das 0,5-Fache der Dicke (d111) der ersten Metallisierungsschicht (111) in der vertikalen Richtung (y) ist; oder
die Tiefe (d1114) der mindestens einen Vertiefung (1114) in der vertikalen Richtung (y) 50 µm kleiner als die Dicke (d111) der ersten Metallisierungsschicht (111) in der vertikalen Richtung (y) ist.

9. Substratanordnung nach einem der Ansprüche 1 bis 8, wobei
ein Durchmesser des Vorsprungs (1112) kleiner als der Innendurchmesser (d3) des Hohlniets (44) ist.

10. Substratanordnung nach einem der vorhergehenden Ansprüche, wobei
ein Durchmesser des Vorsprungs (1112) in einer horizontalen Ebene zwischen 50 µm und 500 µm kleiner als der Innendurchmesser (d3) des Hohlniets (44) ist.

11. Substratanordnung nach einem der vorhergehenden Ansprüche, wobei
eine Höhe des Vorsprungs (1112) in der vertikalen Richtung (y) zwischen 100 µm und 2 mm beträgt.

12. Substratanordnung nach einem der vorhergehenden Ansprüche, wobei der Hohlniet (44) einen röhrenförmigen Teil und mindestens eine Einfassung (442) umfasst, die den röhrenförmigen Teil in der vertikalen Richtung (y) abschließt, wobei die mindestens eine Einfassung (442) eine abgerundete Form aufweist und sich in einer horizontalen Richtung von dem röhrenförmigen Teil erstreckt.

13. Verfahren, das Folgendes umfasst:
Anordnen einer Verbindungsschicht (46) auf einem Substrat (10), wobei das Substrat (10) eine dielektrische Isolationsschicht (11) und eine erste Metallisierungsschicht (111) umfasst, die an der dielektrischen Isolationsschicht (11) angebracht ist; und
Anordnen eines Hohlniets (44) auf der Verbindungsschicht (46), wobei
die erste Metallisierungsschicht (111) mindestens einen Vorsprung (1112) und/oder mindestens eine Vertiefung (1114) umfasst,
die Verbindungsschicht (46) auf dem Substrat (10) so angeordnet wird, dass sie den mindestens einen Vorsprung (1112) und/oder die mindestens eine Vertiefung (1114) zumindest teilweise bedeckt, **dadurch gekennzeichnet, dass**
der Hohlniet (44) derart auf der Verbindungsschicht (46) angeordnet wird, dass die Verbindungsschicht (46) zwischen dem Hohlniet (44) und der ersten Metallisierungsschicht (111) und zwischen dem Hohlniet (44) und dem mindestens einen Vorsprung (1112) und/oder der mindestens einen Vertiefung (1114) angeordnet wird, wobei
jeder des mindestens einen Vorsprungs (1112) eine Vertiefung auf seiner oberen Fläche umfasst, wobei eine obere Fläche des Vorsprungs (1112) eine von der ersten Metallisierungsschicht (111) abgewandte Fläche ist, und der Vorsprung (1112), wenn die zulaufende Spitze eines Anschlusselements (4) in die Vertiefung auf der oberen Fläche des Vorsprungs (1112) gedrückt wird und eine Kraft mit dem Anschlusselement (4) in einer vertikalen Richtung (y) ausgeübt wird, dazu ausgelegt ist, sich teilweise zu teilen und gegen den Hohlniet (44) zu verstemmen.

14. Verfahren nach Anspruch 13, wobei der mindestens eine Vorsprung (1112) mittels eines Kaltspritzprozesses, eines elektrolytischen Abscheidungsprozesses oder eines Kugelbondprozesses gebildet wird.

## Revendications

1. Un agencement de substrat comprenant :
un substrat (10) comprenant une couche (11) diélectrique isolante et une première couche (111) de métallisation rattachée à la couche (11) diélectrique isolante ;
une couche (46) de connexion disposée sur la première couche (111) de métallisation ; et
un rivet (44) creux, dans lequel
la première couche (111) de métallisation comprend au moins une protubérance (1112), la couche (46) de connexion recouvre au moins en partie la au moins une protubérance (1112), et
le rivet (44) creux est disposé sur la couche (46) de connexion, de manière à ce que la couche (46) de connexion soit disposée entre le rivet (44) creux et la première couche (111) de métallisation et entre le rivet (44) creux et la au moins une protubérance (1112), **caractérisé en ce que**
chacune de la au moins une protubérance (1112) comprend un creux sur sa surface de sommet, dans lequel
une surface de sommet de la protubérance (1112) est une surface, qui fait face en en étant loin de la première couche (111) de métallisation, et
la protubérance (1112) est, lorsque la pointe pointue d'un élément (4) de borne est pressée dans le creux sur la surface de sommet de la protubérance (1112) et lorsqu'une force est appliquée par l'élément (4) de borne dans une direction (y) verticale, configurée pour se fendre en partie et se mater sur le rivet (44) creux.

2. L'agencement de substrat de la revendication 1, dans lequel la couche (46) de connexion est disposée entre le rivet (44) creux et la première couche (111) de métallisation dans la direction (y) verticale et entre le rivet (44) creux et la au moins une protubérance (1112) dans un plan horizontal perpendiculaire à la direction (y) verticale.

3. L'agencement de substrat de la revendication 1 ou 2, dans lequel
chacune de la au moins une protubérance (1112) a une forme cylindrique en forme de cube ou sphérique.

4. L'agencement de substrat de la revendication 3, dans lequel
la première couche (111) de métallisation comprend en outre un creux (1114) formant une boucle fermée,
le creux (1114) a un diamètre (d1) intérieur et un diamètre (d2) extérieur,
le rivet (44) creux forme une boucle fermée ayant un diamètre (d3) intérieur et un diamètre (d4) extérieur,
le diamètre (d1) intérieur du creux (1114) est plus petit que le diamètre (d3) intérieur du rivet (44) creux, et
le diamètre (d2) extérieur du creux (1114) est plus grand que le diamètre (d4) extérieur du rivet (44) creux.

5. L'agencement de substrat de la revendication 4, dans lequel au moins l'un de
le diamètre (d1) intérieur du creux (1114) est plus petit d'entre 50 µm et 500 µm que le diamètre (d3) intérieur du rivet (44) creux, et
le diamètre (d2) extérieur du creux (1114) est plus grand, compris entre 50 µm et 2 mm que le diamètre (d4) extérieur du rivet (44) creux.

6. L'agencement de substrat de la revendication 5, dans lequel le diamètre (d2) extérieur du creux (1114) est plus grand, d'entre 100 µm et 400 µm, que le diamètre (d4) extérieur du rivet (44) creux.

7. L'agencement de substrat de l'une quelconque des revendications 4 à 6, dans lequel une épaisseur (d111) de la première couche (111) de métallisation dans la direction (y) verticale est plus grande qu'une profondeur (d1114) du au moins un creux (1114) en la même direction.

8. L'agencement de substrat de la revendication 7, dans lequel
ou bien la profondeur (d1114) du au moins un creux (1114) dans la direction (y) verticale est comprise entre 100 µm et 0,95 mm ; ou bien
la profondeur (d1114) du au moins un creux (1114) dans la direction (y) verticale représente 0,5 fois l'épaisseur (d111) de la première couche (111) de métallisation dans la direction (y) verticale ; ou bien
la profondeur (d1114) du au moins un creux (1114) dans la direction (y) verticale est plus petite de 50 µm que l'épaisseur (d111) de la première couche (111) de métallisation dans la direction (y) verticale.

9. L'agencement de substrat de l'une quelconque des revendications 1 à 8, dans lequel
un diamètre de la protubérance (1112) est plus petit que le diamètre (d3) intérieure du rivet (44) creux.

10. L'agencement de substrat de l'une quelconque des revendications précédentes, dans lequel
un diamètre de la protubérance (1112) dans un plan horizontal est plus petit, d'entre 50 µm et 500 µm, que le diamètre (d3) intérieur du rivet (44) creux.

11. L'agencement de substrat de l'une quelconque des revendications précédentes, dans lequel
une hauteur de la protubérance (1112) dans la direction (y) verticale est comprise entre 100 µm et 2 mm.

12. L'agencement de substrat de l'une quelconque des revendications précédentes, dans lequel le rivet (44) creux comprend une partie tubulaire et au moins un collet (442), qui termine la partie tubulaire dans la direction (y) verticale, dans lequel le au moins un collet (442) a une forme arrondie et s'étend à partir de la partie tubulaire dans une direction horizontale.

13. Un procédé comprenant :
mettre une couche (46) de connexion sur un substrat (10), le substrat (10) comprenant une couche (11) diélectrique isolante et une première couche (111) de métallisation rattachée à la couche (11) diélectrique isolante ; et
mettre un rivet (44) creux sur la couche (46) de connexion, dans lequel la première couche (111) de métallisation comprend au moins une protubérance (1112) et/ou au moins un creux (1114),
la couche (46) de connexion est mise sur le substrat (10), de manière à recouvrir au moins en partie la au moins une protubérance (1112) et/ou le au moins un creux (1114), **caractérisé en ce que**
le rivet (44) creux est mis sur la couche (46) de connexion, de manière à ce que la couche (46) de connexion soit disposée entre le rivet (44) creux et la première couche (111) de métallisation et entre le rivet (44) creux et la au moins une protubérance (1112) et/ou le au moins un creux (1114), dans lequel
chacune de la au moins une protubérance (1112) comprend un creux sur sa surface de sommet, dans lequel une surface de sommet de la protubérance (1112) est une surface, qui fait face en en étant loin de la première couche (111) de métallisation, et
la protubérance (1112) est, lorsque la pointe pointue d'un élément (4) de borne est pressée dans le creux sur la surface de sommet de la protubérance (1112) et lorsqu'une force est appliquée par l'élément (4) de borne dans une direction (y) verticale, configurée pour se fendre en partie et se mater sur le rivet (44) creux.

14. Le procédé de la revendication 13, dans lequel la au moins une protubérance (1112) est formée au moyen d'une opération de pulvérisation à froid, d'une opération de dépôt électrolytique ou un procédé de soudure par bille.
